(19) Europäisches Patentamt

European Patent Office

Office européen des brevets

(11) **EP 0 917 261 B1**

(12) **FASCICULE DE BREVET EUROPEEN**

(45) Date de publication et mention
de la délivrance du brevet:
**24.10.2001 Bulletin 2001/43**

(51) Int Cl.7: **H01S 5/10**, H01S 3/081,
H01S 3/1055, H01S 3/105

(21) Numéro de dépôt: **98403194.8**

(22) Date de dépôt: **13.09.1995**

(54) **Source laser monomode accordable en longueur d'onde à cavité externe autoalignée**

Wellenlängenabstimmbare monomodige Laserquelle mit selbstausrichtendem externen Resonator

Wavelength tunable monomode laser source with self-aligning external cavity

(84) Etats contractants désignés:
**DE FR GB**

(30) Priorité: **13.09.1994 FR 9410925**

(43) Date de publication de la demande:
**19.05.1999 Bulletin 1999/20**

(62) Numéro(s) de document de la (des) demande(s)
initiale(s) en application de l'article 76 CBE:
**95402073.1 / 0 702 438**

(73) Titulaire: **PHOTONETICS**
**78160 Marly le Roi (FR)**

(72) Inventeurs:
 • **Lefevre, Hervé**
  **75014 Paris (FR)**
 • **Martin, Philippe**
  **78760 Pontchartrain (FR)**
 • **Laloux, Bernard**
  **78450 Villepreux (FR)**
 • **Graindorge, Philippe**
  **21800 Chevigny St Sauveur (FR)**
 • **Disdier, Laurent**
  **78160 Marly le Roi (FR)**

(74) Mandataire: **Michelet, Alain et al**
 **Cabinet Harlé et Phélip**
 **7, rue de Madrid**
 **75008 Paris (FR)**

(56) Documents cités:
**WO-A-94/08371**

• **PATENT ABSTRACTS OF JAPAN vol. 5, no. 163 (E-78) [835], 20 octobre 1981 & JP 56 090642 A (KIYOUTO GIKEN), 22 juillet 1981**
• **PATENT ABSTRACTS OF JAPAN vol. 6, no. 185 (E-132) [1063], 21 septembre 1982 & JP 57 099793 A (T. TOMIJIMA), 21 juin 1982**
• **K.LIU, M.G.LITTMAN: "Novel Geometry for Single-Mode Scanning of Tunable Lasers" OPTICS LETTERS, vol. 6, no. 3, pages 117-118, XP000710138 WASHINGTON, US**
• **F.FAVRE, D.LE GUEN: "82nm of Continuous Tunability for an External Cavity Semiconductor Laser" ELECTRONIS LETTERS, vol. 27, no. 2, 17 janvier 1991, pages 183-184, XP000201222 STEVENAGE, GB**
• **G.Z.ZHANG, K.HAKUTA: "Scanning geometry for broadly tunable single-mode pulsed dye lasers" OPTICS LETTERS, vol. 17, no. 14, 15 juillet 1992, pages 997-999, XP000288960 NEW YORK, US**
• **M.G.LITTMAN: "Single-mode pulsed tunable dye laser" APPLIED OPTICS, vol. 23, no. 24, 15 décembre 1984, pages 4465-4468, XP000709276 NEW YORK, US**
• **R.S.PUTMAN: "Laser-mode spacing is independent of cavity length" CONFERENCE ON LASERS AND ELECTRO-OPTICS (CLEO) - TECHNICAL DIGEST SERIES, vol. 12, 10 mai 1992, pages 306-308, XP000351496 WASHINGTON**

## Description

La présente invention concerne une source laser monomode accordable en longueur d'onde à cavité externe.

On sait qu'une cavité optique résonnante d'une source laser sélectionne une ou plusieurs longueurs d'onde émises par un milieu amplificateur laser. Il s'agit le plus souvent de deux miroirs dont l'un partiellement transparent, formant une cavité dite de Fabry-Perot. Une telle cavité de Fabry-Perot sélectionne, ou résonne pour des demi-longueurs d'onde égales à des sous-multiples de la longueur optique $L_{op}$ de la cavité et donc en général très proches les unes des autres. Plusieurs longueurs d'onde sont alors susceptibles d'être amplifiées par le milieu amplificateur à spectre large. On obtient ainsi un laser multimode.

Pour certaines applications, des lasers monomodes sont préférés. Il est alors nécessaire de mettre en oeuvre une cavité optique résonnante associant un moyen de sélection complémentaire de la cavité de Fabry-Perot, par exemple de remplacer l'un de ses miroirs par un dispositif dispersif rétroréfléchissant.

Les dispositifs dispersifs rétroréfléchissants sont couramment utilisés en optique traditionnelle. Le dispositif le plus connu est probablement le réseau plan de pas p utilisé selon la configuration de Littrow.

De manière générale, un réseau plan de pas p a un plan de dispersion perpendiculaire à ses traits. Un faisceau lumineux collimaté de longueur d'onde $\lambda$, incliné d'un angle $\theta_1$ par rapport à la normale du réseau qui est parallèle au plan de dispersion du réseau, produit un faisceau collimaté également parallèle au plan de dispersion et ayant une direction inclinée d'un angle $\theta_2$ par rapport à la normale, $\theta_1$ et $\theta_2$ étant liés par la relation :

$$p \sin \theta_1 + p \sin \theta_2 = \lambda$$

La configuration de Littrow dans laquelle ce réseau se comporte en système dispersif rétroréfléchissant, correspond au cas où $\theta_1 = \theta_2 = \theta$, c'est à dire :

$$2 p \sin \theta = \lambda$$

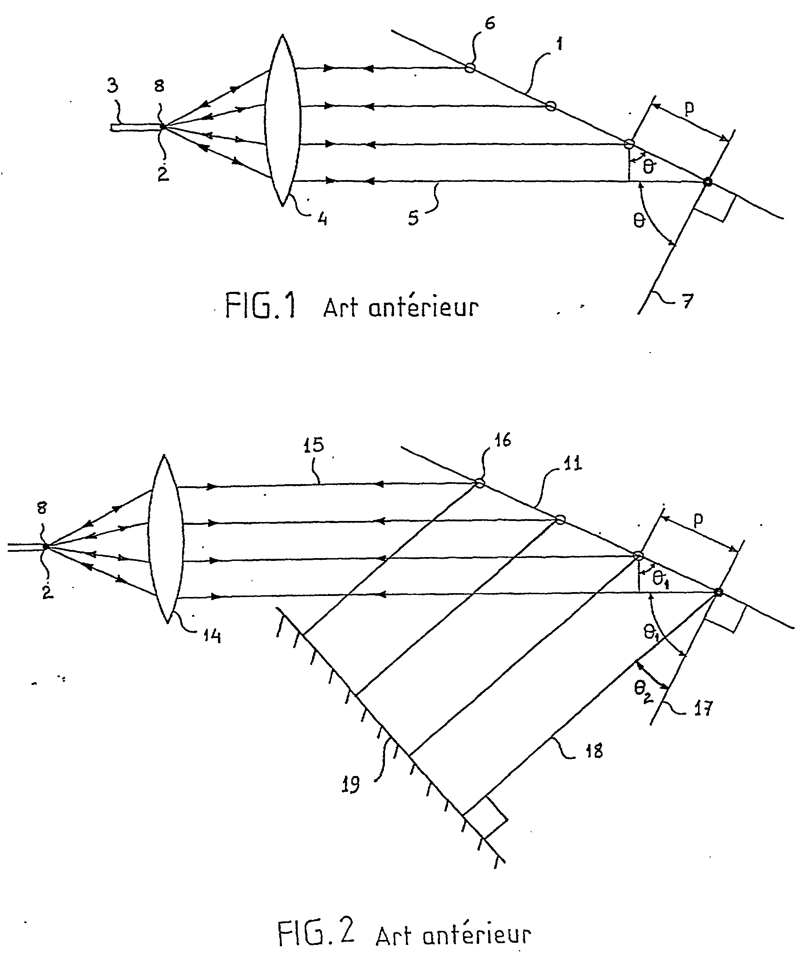

La Figure 1 représente un réseau 1 mis en oeuvre selon le montage de Littrow, dans lequel une extrémité 2 d'un milieu amplificateur guidé 3 est placée au foyer d'une optique de collimation 4 qui produit un faisceau parallèle collimaté 5 de longueur d'onde $\lambda$.

Ce faisceau est parallèle au plan de dispersion du réseau, c'est-à-dire au plan perpendiculaire aux traits 6 du réseau 1, et forme un angle $\theta$ avec la normale 7 à la surface du réseau 1.

On sait dans ces conditions que p étant le pas du réseau, lorsque la relation $2p \sin \theta = \lambda$ est vérifiée,

le faisceau 5 est renvoyé par le réseau 1 sur lui-même et produit donc un point-image 8 confondu avec l'extrémité 2.

De tels dispositifs dispersifs rétroréfléchissants ont été utilisés, par exemple, pour constituer l'un des systèmes rétroréfléchissants d'un cavité laser résonnante, de manière à sélectionner l'une ou certaines des raies susceptibles d'être produites par la cavité. On connaît par exemple par le brevet français FR-2.595.013, des sources laser monomodes accordables, dans lesquelles la longueur d'onde d'émission est sélectionnée dans le spectre large d'un guide d'onde amplificateur avec une cavité externe comportant un réseau dispersif rétroréfléchissant en configuration de Littrow. Un mouvement changeant l'orientation angulaire de ce dispositif dispersif permet de faire varier la longueur d'onde sélectionnée et émise par la source laser accordable à cavité externe.

Dans ces différents dispositifs, la longueur d'onde rétroréfléchie dépend de l'orientation angulaire d'un réseau autour d'un axe parallèle à ses traits et donc perpendiculaire au plan de dispersion. Cet axe est appelé l'axe de sélection.

Il est aussi connu que de telles sources lasers accordables à cavité externe peuvent fonctionner avec une configuration dite de Littman-Metcalf où le faisceau collimaté incident fait un angle $\theta_1$ avec la normale au réseau. Un miroir additionnel est placé avec sa normale ayant un angle $\theta_2$ sur le réseau. La longueur d'onde $\lambda$ qui respecte $\lambda = p \sin \theta_1 + p \sin \theta_2$ est dispersée par le réseau à un angle $\theta_2$, puis est rétroréfléchie sur le miroir qui lui est alors perpendiculaire, et enfin est dispersée de nouveau dans le réseau en retour et ressort à l'angle $\theta_1$ d'entrée. Cette longueur d'onde $\lambda$ est donc sélectionnée dans la cavité. L'accordabilité en longueur d'onde est obtenue en faisant varier l'orientation de l'ensemble réseau-miroir, c'est-à-dire en faisant varier $\theta_1$, ou bien en faisant varier uniquement l'orientation du miroir, c'est-à-dire en faisant varier $\theta_2$ ou enfin en faisant varier uniquement l'orientation du réseau, c'est-à-dire en faisant varier $\theta_1$ et $\theta_2$ tout en conservant $\theta_1 - \theta_2$ constant.

La Figure 2 représente un réseau 11 mis en oeuvre selon le montage de Littman-Metcalf dans lequel une extrémité 2 d'un milieu amplificateur guidé 13 est placée au foyer d'une optique de collimation 14 qui produit un faisceau collimaté principal 15 de longueur d'onde $\lambda$.

Ce faisceau est parallèle au plan de dispersion du réseau, c'est-à-dire au plan perpendiculaire aux traits 16 du réseau 11, et forme un angle $\theta_1$ avec la normale 17 à la surface du réseau 11. Par diffraction sur le réseau, le faisceau 14 produit un faisceau collimaté secondaire 18 qui est dans le plan de dispersion et forme un angle $\theta_2$ avec la normale 17. Un miroir plan 19 est placé perpendiculairement au faisceau 18 et le faisceau se rétroréfléchit à travers l'ensemble du système.

On sait dans ces conditions que p étant le pas du réseau, lorsque la relation $p \sin \theta_1 + p \sin \theta_2 = \lambda$ est

vérifiée, le faisceau 15 revient sur lui-même après une première diffraction sur le réseau 11, une rétroréflexion sur le miroir 19 et une deuxième diffraction sur le réseau 11. Il produit donc un point-image 8 confondu avec l'extrémité 2.

Le réglage de tels dispositifs nécessite le positionnement précis du réseau autour d'un axe perpendiculaire à l'axe de sélection et parallèle au plan de dispersion. Ce dernier réglage et sa stabilité sont très délicats et conditionnent, dans la plupart des cas, la qualité du résultat obtenu.

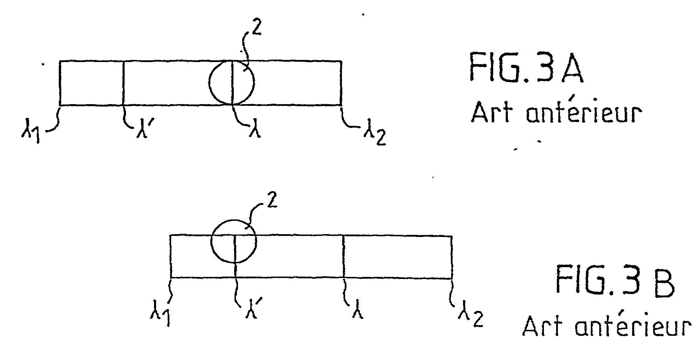

Afin d'éclaircir cet exposé, on a représenté sur la Figure 3A une vue du plan focal de l'optique de collimation, dans lequel se trouve l'extrémité 2 d'un milieu amplificateur guidé et le spectre produit en retour par les montages des Figures 1 et 2, lorsque l'amplificateur émet un spectre large. On obtient ainsi un spectre s'étendant d'une longueur d'onde $\lambda_1$ à une longueur d'onde $\lambda_2$, et pour lequel la longueur d'onde $\lambda$ est rétroréfléchie sur l'extrémité 2 et est donc sélectionnée dans la cavité.

En pratique, l'axe de rotation réel ne pouvant être exactement parallèle aux traits du réseau, le déplacement du spectre dans le plan focal s'accompagnera d'un mouvement perpendiculaire à celui-ci et conduira, lorsque la longueur d'onde $\lambda'$ sera rétroréfléchie, à une configuration telle que celle représentée sur la Figure 3B, dans laquelle la rétroréflexion n'est pas exactement obtenue en raison du décalage du spectre. perpendiculairement à lui-même, en même temps que parallèlement à lui-même dans le plan focal de l'optique de collimation.

Par exemple, en utilisant comme milieu amplificateur une diode laser qui produit un spectre s'étendant, dans un premier cas, de 1470 à 1570 nm et, dans un deuxième cas, de 1260 à 1340 nm. Lorsque l'on souhaite modifier la longueur d'onde rétroréfléchie qui devient alors $\lambda'$, compte tenu de la relation de Littrow indiquée plus haut, cela est réalisé par la rotation du réseau qui devrait, si elle était réalisée autour d'un axe parallèle aux traits 6 du réseau, produire une simple translation du spectre $\lambda_1$, $\lambda_2$ et amener la longueur d'onde $\lambda'$ en coïncidence avec l'extrémité 2.

Dans la configuration de Littman-Metcalf, le même problème se pose quand le réseau 11, ou bien le miroir 19 ou bien l'ensemble des deux, subissent une rotation autour d'un axe parallèle aux traits 16 du réseau.

De tels dispositifs peuvent aussi générer des sauts de modes. En effet, la rotation du dispositif dispersif à réseau change la longueur d'onde sélectionnée mais cette longueur d'onde doit aussi respecter la condition de résonance de toute cavité optique qui indique que la longueur optique $L_{op}$ de la cavité est égale à un nombre entier N de demi-longueur d'onde :

$$L_{op} = N \cdot \lambda/2$$

Si la longueur d'onde sélectionnée diminue, il faut donc raccourcir en même temps la cavité, et inversement la rallonger quand la longueur d'onde augmente, pour rester sur le même nombre entier N et éviter les sauts de modes.

Un tel dispositif d'accordabilité continue sans saut de mode a été proposé avec une configuration de Littrow (F. Favre et D. Le Guen, "*82 nm of continuous tunability for an external cavity semi-conductor laser*", Electronics Letters, Vol. 27, 183-184, [1991]), mais il nécessite un ensemble mécanique complexe utilisant deux mouvements de translation et deux mouvements de rotation.

Dans un article de 1981, LIU et LITTMAN (Optics Letters, vol. 6, N° 3, Mars 1981, pp. 117-118) décrivent un dispositif comportant un réseau et un miroir d'orientation variable mis en oeuvre pour la réalisation d'un laser monomode de longueur d'onde variable. La géométrie proposée permet d'assurer un balayage en longueur d'onde sans rupture.

Par ailleurs, les dièdres réflecteurs ont été étudiés de longue date. En particulier, la demande de brevet japonais JP-A-57.099793 du 21 Juin 1981 propose d'utiliser un tel dièdre pour réaliser un dispositif dispersif rétroréfléchissant dans un système de communication à fibre optique multiplexé en longueurs d'onde, ces longueurs sont fixes.

La demande de brevet JP-A-560,90642 divulgue un système de communication optique, permettant une communication multiplexée par différenciation de longueur d'onde. Ce système comprend plusieurs lasers semi-conducteurs, chacun d'entre eux émettant une lumière et la recevant après deux diffractions sur un réseau, au moyen d'un miroir, à une longueur d'onde fixée par la position de ce laser.

La technique décrite dans ce document est inadaptée à un ajustement en longueur d'onde d'une source laser.

L'objectif de l'invention est de proposer une cavité laser accordable présentant une grande tolérance de réglage du dispositif dispersif rétroréfléchissant autour d'un axe perpendiculaire à l'axe du faisceau collimaté secondaire et parallèle au plan de dispersion et ayant donc une grande stabilité mécanique, tout en rendant possible une accordabilité continue sans saut de mode.

L'invention est définie par la revendication 1. Divers modes de réalisation sont définis par les revendications dépendantes.

A cet effet, l'invention concerne une source laser monomode accordable en longueur d'onde, à cavité externe autoalignée, comportant :

une cavité résonnante ayant une face de sortie partiellement réfléchissante et un dispositif dispersif rétroréfléchissant, définissant un axe de collimation principal et un axe de collimation secondaire, un guide d'onde amplificateur placé à l'intérieur de la cavité résonnante.

Selon l'invention, le dispositif dispersif rétroréfléchissant comporte un réseau plan ayant des plans de dispersion et un dièdre réflecteur orthogonal dont l'arête est parallèle au plan de dispersion du réseau comprenant les axes de collimation. De plus, le réseau et le dièdre ayant chacun une orientation, la source laser comprend des moyens d'ajustement de l'orientation du réseau et/ou du dièdre.

Préférentiellement :

le point A étant le point d'intersection des axes de collimation et du réseau,
le point B' étant l'extrémité optique de la cavité située du côté du dièdre réflecteur,
le point C' étant l'intersection de l'axe de collimation principal avec l'extrémité optique de la cavité située du côté du milieu amplificateur,
le point D étant l'intersection du plan contenant la face de diffraction du réseau et de la parallèle à l'arête du dièdre passant par B',

o l'angle AC'D est maintenu égal à 90°,
o la longueur AD est maintenue constante,

de façon à réaliser une source continûment accordable.

Ainsi, un déplacement du dispositif dispersif autoaligné utilisant une simple rotation peut permettre d'obtenir une accordabilité continue sans sauts de mode.

Dans différents modes de réalisation présentant chacun leurs avantages spécifiques, le dispositif de l'invention présente les caractéristiques suivantes, éventuellement combinées :

- Les mouvements du réseau et du dièdre sont liés de telle sorte qu'ils sont mobiles ensemble et fixes l'un relativement à l'autre.
- Le réseau et le dièdre sont portés par une platine mobile en rotation autour d'un axe de rotation passant par le point A, ladite platine étant solidaire d'un bras d'axe, ce bras ayant un point d'appui sur un plan fixe de translation, par rapport à un bâti, l'axe de rotation étant porté par un élément mobile d'un mouvement de translation parallèle à l'axe de faisceau collimaté, par rapport au bâti, l'accordabilité continue de la source étant obtenue par le déplacement de l'élément mobile et le maintien du point d'appui sur le plan.
- Un ressort de rappel, fixé à l'une de ses extrémités à un bras de la platine et à l'autre de ses extrémités au bâti, assure le maintien du point d'appui sur le plan.
- Le réseau est fixe et le dièdre est mobile.
- Le dièdre est porté par un support mobile autour d'un axe, perpendiculaire au plan de dispersion et passant par le point D.

- Le réseau est porté par un bâti et un moteur, solidaire du bâti et actionnant un poussoir lié au support, commande l'orientation du dièdre.
- Le milieu amplificateur est une diode laser.
- L'une des faces de la diode laser est faiblement réfléchissante et constitue une face de sortie vers la cavité externe.
- Le milieu amplificateur est une fibre optique dopée.
- Un faisceau collimaté produit par la réflexion ordinaire sur le réseau constitue une source utile.

L'invention sera décrite en détail par référence aux dessins annexés, dans lesquels :

- la Figure 1 est un montage traditionnel de l'art antérieur selon la configuration de Littrow ;
- la Figure 2 est un montage traditionnel de l'art antérieur selon la configuration de Littman-Metcalf ;
- les Figures 3A et 3B sont une représentation schématique du spectre lumineux rétroréfléchi dans le plan de la source, pour deux orientations différentes du réseau de la Figure 1, ou bien du réseau, ou du miroir de la Figure 2 ;
- la Figure 4 est une représentation vue de dessus de la cavité laser accordable autoalignée de l'invention ;
- la Figure 5 est une représentation de ce même dispositif vue de face ;
- la Figure 6 est une vue de côté de ce même dispositif ;

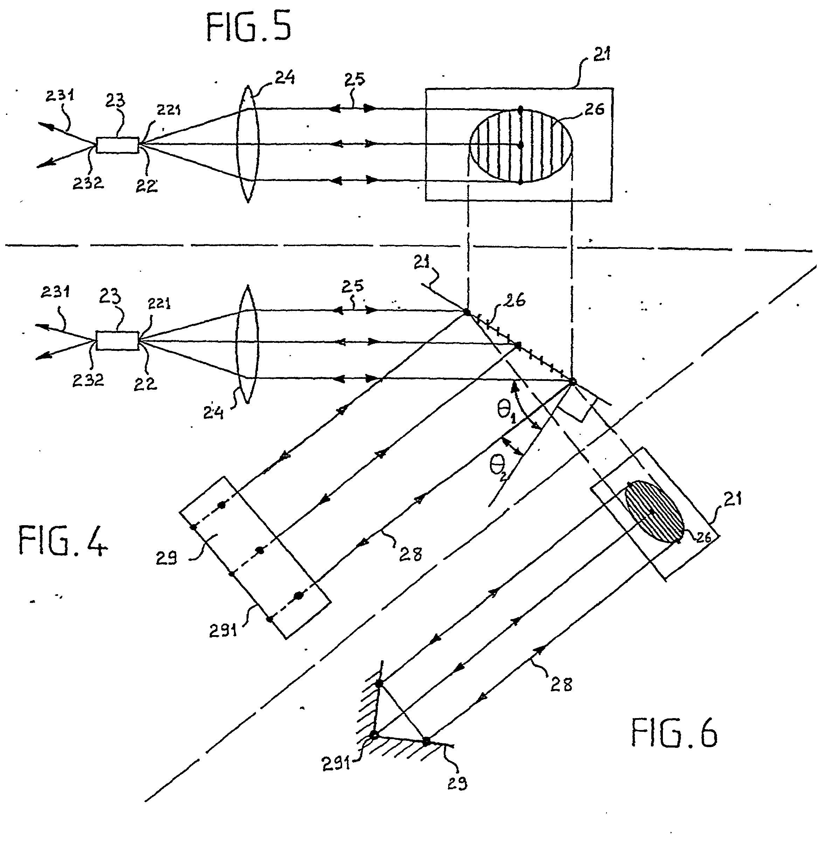

- Les Figures 4, 5, 6 ont été représentées sur la même feuille et séparées les unes des autres par des lignes hachurées parallèles aux faisceaux collimatés pour permettre l'établissement de correspondances entre les éléments de ces différentes Figures.

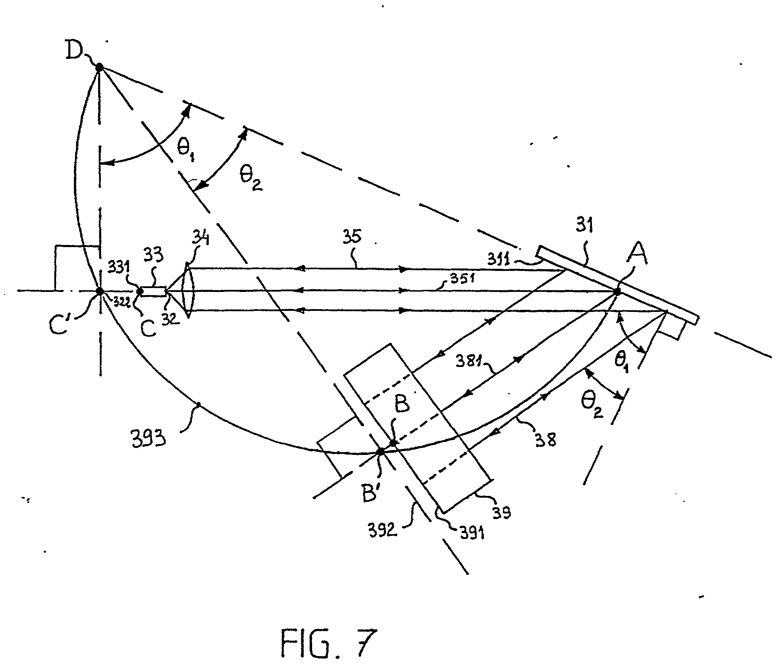

- la Figure 7 représente une cavité laser continûment accordable et autoalignée selon l'invention ;

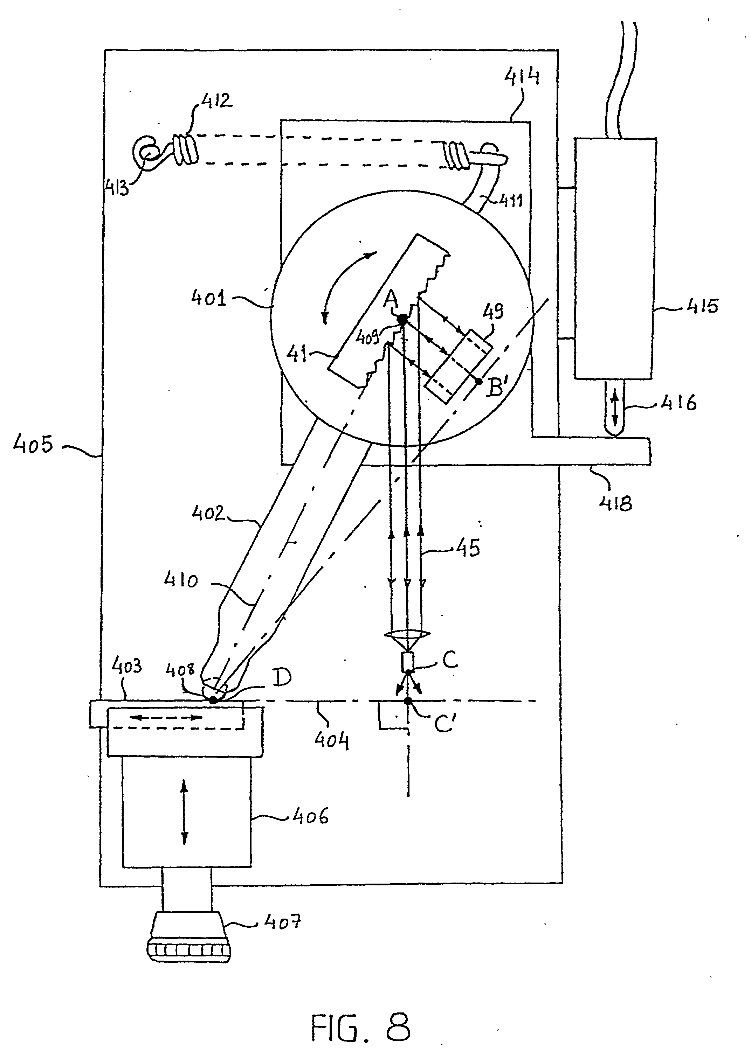

- la Figure 8 représente une cavité laser continûment accordable et autoalignée selon l'invention, utilisant un mouvement combiné de deux translations :

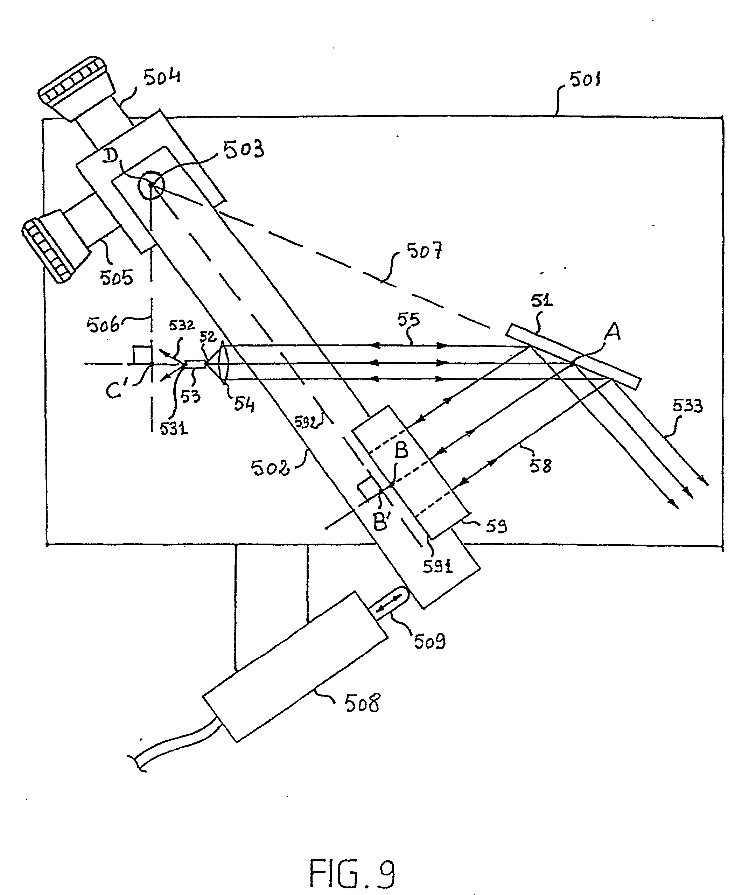

- la Figure 9 représente une cavité laser continûment accordable et autoalignée selon l'invention, utilisant un simple mouvement de rotation.

Le dispositif de l'invention comporte un réseau 21 travaillant avec un milieu amplificateur guidé 23, possédant une extrémité interne 22 faisant face au réseau 21 et qui, par l'intermédiaire d'une optique de collimation 24, produit un faisceau collimaté 25 de longueur d'onde $\lambda$. Ce faisceau 25 dispersé par le réseau 21 fournit un faisceau diffracté 28.

Ce réseau est un réseau plan qui peut être un réseau gravé ou un réseau holographique fonctionnant en réflexion ou en transmission. La description qui suit est faite dans le cas d'un réseau fonctionnant en réflexion.

On appelle plan de dispersion, le plan perpendiculaire aux traits 26 du réseau 21 contenant l'extrémité 22 du milieu amplificateur guidé 23.

Ce dispositif comporte de plus un dièdre orthogonal 29 qui réfléchit le faisceau 28 qui revient sur lui-même, puis après diffraction sur le réseau 21, revient confondu avec le faisceau 25. Le système optique de collimation 24 focalise l'image de retour en 221.

Ce dispositif fournit un faisceau divergent 231 par la face de sortie 232 du milieu amplificateur 23.

Le dièdre orthogonal 29 est composé de deux miroirs plans ayant précisément un angle de 90°. Il peut être formé de deux miroirs plans assemblés, ou par un prisme isocèle rectangle, dont la face d'entrée correspondant à l'hypoténuse du triangle isocèle rectangle est traitée antireflet.

De préférence, le milieu amplificateur guidé 23 est une diode laser ou bien une fibre optique dopée ayant une extrémité interne 22 ayant extrémité interne 22.

Ainsi, seule la longueur d'onde du faisceau 25 dispersée par le réseau 21, perpendiculairement à l'arête 291 du dièdre 29, est rétroréfléchie, et produit une image 221 superposée à l'extrémité 22. C'est ce qui produit la sélection en longueur d'onde et exploite ainsi la dispersion du réseau 21.

L'orientation du dièdre 29 autour de son arête 291, par rapport au plan de dispersion du réseau 11, ne requiert pas une grande précision. En effet, on sait qu'avec le dièdre orthogonal 29, un rayon incident contenu dans un plan parallèle à l'arête 291 est renvoyé dans un plan parallèle au plan incident. La précision du parallélisme dépend de la précision de l'angle droit formé par les deux faces réfléchissantes du dièdre 29, qui est fixé par construction avec une très bonne précision (quelques secondes d'arc par exemple). Ainsi, l'ensemble formé par le réseau 21 et le dièdre 29 constitue un dispositif rétroréflecteur autoaligné.

Le dièdre 29 compense aussi les instabilités de l'orientation du réseau 21 autour d'axes parallèles au plan de dispersion.

Le mouvement du dispositif rétroréflecteur autoaligné dans son ensemble ou les mouvements séparés de ces composants permettent de changer la longueur de la cavité dans le même rapport que le changement de longueur d'onde, afin d'assurer une accordabilité continue sans saut de mode. La Figure 7 décrit une source laser autoalignée continûment accordable ainsi obtenue. Un milieu amplificateur guidé 33 a une extrémité interne 32 placée au foyer d'une optique de collimation 34 qui produit un faisceau collimaté 35. Ce faisceau est dispersé sur un réseau plan 31. Le faisceau dispersé 38 est rétroréfléchi sur un dièdre orthogonal 39 ayant une arête 391. On appelle A le point d'intersection de l'axe central 351 du faisceau collimaté 35 avec le réseau 31. On appelle B le point d'intersection de l'axe central 381 du faisceau collimaté 38 avec l'arête 391 qui est une des extrémités physiques de la cavité. Si le dièdre est un prisme isocèle rectangle d'indice de réfraction $n_d$, l'extrémité optique de la cavité est déplacée sur la ligne virtuelle 392 et B' est le point d'intersection de cette ligne 392 et de l'axe central du faisceau collimaté 38. La longueur géométrique AB' est donc égale à la longueur optique de la partie de la cavité située entre A et B.

On appelle ici, comme en interférométrie, longueur optique d'un élément , le produit de sa longueur géométrique par l'indice de réfraction du milieu qui le compose.

L'autre extrémité physique de la cavité est la face de sortie 331 du milieu amplificateur guidé 33. On appelle C l'intersection de l'axe central du faisceau 35 avec la face de sortie 331 et C' celle avec l'extrémité optique 322 de la cavité, reculée à cause de l'indice du milieu amplificateur 33 et celui de l'optique de collimation 34. La longueur géométrique AC' est quant à elle égale à la longueur optique de la partie de la cavité placée entre A et C.

La longueur optique $L_{op}$ de la cavité est donc :

$$L_{op} = (AB' + AC')$$

On définit le point D comme l'intersection du plan contenant la face 311 diffractante du réseau 31 avec la droite 392 parallèle à l'arête 391 et passant par B'. Le triangle AB'D est rectangle en B' puisque le faisceau dispersé 38 est lui-même perpendiculaire à l'arête 391.

L'accordabilité continue est obtenue quand le mouvement du dièdre et du réseau respecte les deux conditions :

• l'angle AC'D est égal à 90° ;
• la longueur AD est constante.

Ces conditions sont réalisées lorsque les points C' et B' restent sur un demi-cercle 393 de diamètre DA, ce diamètre conservant une longueur constante.

En effet la condition de résonance de la cavité est :

$$L_{op} = (AC' + AB') = N \lambda / 2$$

où

$L_{op}$ est la longueur optique de la cavité,
$\lambda$ est la longueur d'onde sélectionnée,
$N$ est un nombre entier.

comme     $AB' = AD \sin \theta_2$ car l'angle AB'D est droit par principe
et     $AC' = AD \sin \theta_1$ car l'angle AC'D est droit selon la première condition ci-dessus
nous avons:

$$AD \, (\sin \theta_1 + \sin \theta_2) = N \, \lambda \, / \, 2$$

La loi de dispersion du réseau étant :

$$p \, (\sin \theta_1 + \sin \theta_2) = \lambda$$

p étant le pas du réseau,
on obtient :

$$\frac{2 \, AD}{p} = N$$

La deuxième condition (longueur AD constante) conduit donc à une valeur constante de N quelque soit λ et donc à une accordabilité continue sans saut de mode.

Ces deux conditions peuvent être obtenues en particulier dans deux modes de réalisation.

Dans un premier mode de réalisation, le réseau et le dièdre sont montés sur un support commun subissant un mouvement combiné de translation du point A parallèlement à AC', et de translation du point D parallèlement à C'D, le triangle rectangle AB'D étant maintenu indéformé et subissant donc une rotation.

On obtient ce résultat lorsque, tels que représentés sur la Figure 8, le réseau 41 et le dièdre 49 sont avantageusement portés par un même support mécanique ou platine tournante 401 solidaire d'un bras 402. Ce bras est en appui sur un plan fixe de translation 403 d'axe 404 perpendiculaire à l'axe du faisceau 45, positionné et réglable par rapport au bâti 405, par l'intermédiaire des moyens de réglage 406 commandés par la vis micrométrique 407. Le point d'appui 408 du bras 402 sur le plan de translation 403 est dans le plan contenant la face diffractante du réseau 41 et l'axe de rotation 409 du réseau 41. Cet axe de rotation 409 définit avec le point d'appui 408, un axe 410. A l'autre extrémité du support 401, une attache 411 est reliée au bâti 405 par l'intermédiaire d'un ressort 412 dont la deuxième extrémité est fixée sur un doigt 413 porté par le bâti 405.

La platine tournante 401 est elle-même fixée sur l'élément mobile d'une platine de translation 414 fixée sur le bâti 405.

Le ressort 412 exerce, sur la platine 401, une force de rappel qui maintient le doigt 402 en contact avec le plan 403. Le moteur 415 commandant la tige de vérin 416 est susceptible de produire le déplacement de l'élément mobile 414 du mouvement de translation en appuyant sur le doigt 418, solidaire de cet élément mobile.

Ainsi, le moteur 415 produisant les déplacements de l'élément mobile du mouvement de translation 414 entraîne l'ensemble formé par le réseau 41 et le dièdre 49, modifiant alors la longueur de la cavité résonnante de la source.

Simultanément, le bras 402, en appui sur le plan de référence 403, produit la rotation de l'ensemble formé par le réseau 41 et le dièdre 49 autour de l'axe 409.

La distance AD entre l'axe de rotation 409 et le point d'appui 408 reste constante au cours de ce mouvement. L'axe 409 correspond au point A de l'explication précédente et le point 408 au point D. Le dièdre 49 est positionné sur la platine tournante 401 de façon à ce que le triangle AB'D soit rectangle en B'. Ceci conduit donc à un montage qui respecte les conditions d'accordabilité continue décrit en référence à la Figure 7.

Un deuxième mode de réalisation utilise un réseau fixe et le dièdre est monté sur un support mobile qui peut tourner autour de l'axe perpendiculaire au plan de dispersion et passant par D.

Le réseau 51, le milieu amplificateur guidé 53 et l'objectif de collimation 54 sont fixés sur un bâti 501. Le dièdre 59 est fixé sur un support mobile 502 tournant autour d'un axe excentré 503, de façon à ce que la droite parallèle 592 à l'arête 591 passant par le point B' qui est l'extrémité optique de la cavité, passe aussi par l'axe 503.

Cet axe 503 est fixé sur un ensemble de mouvements de translation 504 et 505 qui permettent de le positionner à l'intersection D de la perpendiculaire 506 à l'axe de la cavité qui passe par C', et de la droite 507 passant par la face du réseau 51. Un moteur 508, fixé sur le bâti 501, actionne une tige 509 qui entraîne la rotation autour de l'axe 503 du support 502 et du dièdre 59 qui y est fixé. Ainsi, le faisceau diffracté 58 qui est sélectionné dans la cavité reste perpendiculaire à l'arête 591.

Pendant une rotation du support mobile 502, le faisceau 58 se déplace latéralement sur le dièdre 59, ainsi que B', le long de la droite 592. Ce déplacement du faisceau est une translation géométrique de celui-ci qui n'implique pas de translation de pièces mécaniques.

Cette deuxième méthode d'obtention de l'accordabilité continue est donc particulièrement pratique du point de vue de l'agencement mécanique, car elle utilise une simple rotation mécanique.

Cette source accordable délivre un faisceau divergent 532 à la sortie 531 du milieu amplificateur 53, mais il est aussi possible d'utiliser facilement le faisceau collimaté 533 qui correspond à la réflexion ordinaire du faisceau 55 sur le réseau 51. Cette réflexion ordinaire, appelée aussi ordre zéro du réseau, garde une direction fixe car le réseau est fixé au bâti et seul le dièdre est mobile pendant le réglage en longueur d'onde.

Dans chacun des modes de réalisation, le milieu amplificateur guidé est avantageusement une diode laser dont l'une des faces constituant son extrémité interne 2, 22, 32, 42, 52 a été rendue très peu réfléchissante par traitement antireflet. Son taux de réflexion est avantageusement inférieur à $10^{-4}$. Cette face permet l'émission d'un flux lumineux qui est dirigé vers le dispositif dispersif rétroréfléchissant.

L'autre de ses faces constituant la face de sortie est partiellement réfléchissante. Elle émet un faisceau divergent constituant le faisceau de sortie de la source. Il peut être utilisé de toute manière classique et, en particulier, être couplé à une fiche optique après traversée d'un isolateur évitant les perturbations qui pourraient être générées par des réflexions parasites revenant dans la source.

Des diodes émettant entre 1470 et 1570 nm d'une part, ou des diodes émettant entre 1260 et 1340 nm d'autre part, permettent d'obtenir de bons résultats.

Ainsi, dans l'ensemble des rayons lumineux émis à l'intérieur de la cavité, celui correspondant à la sélection réalisée par le système dispersif 11. 21 est sélectionné et donc susceptible de résonner pour produire une émission laser.

Les signes de référence insérés après les caractéristiques techniques mentionnées dans les revendications, ont pour seul but de faciliter la compréhension de ces dernières, et n'en limitent aucunement la portée.

**Revendications**

1. Source laser monomode accordable en longueur d'onde, à cavité externe autoalignée, comportant :

   une cavité résonnante ayant une face de sortie partiellement réfléchissante (232) et un dispositif dispersif rétroréfléchissant (31, 39), définissant pour un faisceau (35) un axe de collimation principal (351) et un axe de collimation secondaire (381),
   un guide d'onde (33) amplificateur qui est placé à l'intérieur de la cavité résonnante et qui produit ledit faisceau (35),

   **caractérisée en ce que** le dispositif dispersif rétroréfléchissant comporte un réseau plan (31) ayant des plans de dispersion et un dièdre réflecteur orthogonal (39) dont l'arête (391) est parallèle au plan de dispersion du réseau comprenant lesdits axes de collimation (351, 381), et **en ce que** le réseau (31) et le dièdre (39) ayant chacun une orientation, la source laser comprend des moyens d'ajustement (401-407, 411-416, 418. 502, 504-505, 508-509) de l'orientation du réseau (31) et/ou du dièdre (39).

2. Source laser monomode accordable selon la revendication 1, **caractérisé en ce que**:

   le point A étant le point d'intersection des axes de collimation (351, 381) et du réseau (31),
   le point B' étant l'extrémité optique de la cavité centrée sur l'axe de collimation secondaire (381) et située du côté du dièdre réflecteur (39),
   le point C' étant l'intersection de l'axe de collimation principal (351) avec l'extrémité optique de la cavité située du côté du milieu amplificateur (33),
le point D étant l'intersection du plan (311) contenant la face de diffraction du réseau (31) avec la parallèle (392) à l'arête du dièdre (31) passant par B',

   o l'angle AC'D est maintenu égal à 90°,
   o la longueur AD est maintenue constante,

de façon à réaliser une source continûment accordable.

3. Source laser monomode accordable selon l'une des revendications 1 et 2, **caractérisée en ce que** les mouvements du réseau (31) et du dièdre (39) sont liés de telle sorte qu'ils sont mobiles ensemble et fixes l'un relativement à l'autre.

4. Source laser monomode continûment accordable selon la revendication 3, **caractérisée en ce que** le réseau (41) et le dièdre (49) sont portés par une platine (401) mobile en rotation autour d'un axe de rotation (409) passant par le point A, ladite platine (401) étant solidaire d'un bras (402) d'axe (410), ce bras (402) ayant un point d'appui (408) sur un plan fixe (403) de translation, par rapport à un bâti (405), l'axe de rotation (409) étant porté par un élément mobile (414) d'un mouvement de translation parallèle à l'axe de faisceau collimaté (45), par rapport au bâti (405), l'accordabilité continue de la source étant obtenue par le déplacement de l'élément mobile (414) et le maintien du point d'appui (408) sur le plan (403).

5. Source laser monomode continûment accordable selon la revendication 4, **caractérisée en ce qu'**un ressort de rappel (412), fixé à l'une de ses extrémités à un bras (411) de la platine (401) et à l'autre de ses extrémités (413) au bâti (405), assure le maintien du point d'appui (408) sur le plan (403).

6. Source laser monomode accordable selon l'une des revendications 1 et 2, **caractérisée en ce que** le réseau est fixe et que le dièdre est mobile.

7. Source laser monomode continûment accordable selon la revendication 6, **caractérisée en ce que** le dièdre (591) est porté par un support (502) mobile autour d'un axe (503), perpendiculaire au plan de dispersion et passant par le point D.

8. Source laser monomode continûment accordable selon la revendication 7, **caractérisée en ce que** le réseau (51) est porté par un bâti (501) et qu'un moteur (508), solidaire du bâti (501) et actionnant un poussoir (509) lié au support (502), commande l'orientation du dièdre (59).

**9.** Source laser monomode accordable selon l'une des revendications 1 à 8, **caractérisée en ce que** le milieu amplificateur est une diode laser.

**10.** Source laser monomode accordable selon la revendication 9, **caractérisée en ce que** l'une des faces de la diode laser est faiblement réfléchissante et constitue la face de sortie vers la cavité externe.

**11.** Source laser monomode accordable selon l'une des revendications 1 à 8, **caractérisée en ce que** le milieu amplificateur est une fibre optique dopée.

**12.** Source laser monomode accordable selon l'une des revendications 6 à 11, **caractérisée en ce qu'**un faisceau collimaté (533) produit par la réflexion ordinaire sur le réseau (51) constitue une source utile.

**Patentansprüche**

**1.** In der Wellenlänge abstimmbare Monomodlaserquelle mit einem externen selbsteinstellenden Resonanzraum, umfassend:

einen Resonanzraum mit einer teilweise reflektierenden Ausgangsfläche (232) und eine rückstrahlende Streuvorrichtung (31, 39), die für einen Strahl (35) eine Hauptkollimationsachse (351) und eine Nebenkollimationsachse (381) definiert,
einen Wellenleiter-Verstärker (33), der im Inneren des Resonanzraumes angeordnet ist, und den genannten Strahl (35) erzeugt,

**dadurch gekennzeichnet, daß** die rückstrahlende Streuvorrichtung ein planes Gitter (31) umfaßt, das ebene Streuflächen und ein orthogonales reflektierendes Dieder (39) aufweist, dessen Schnittkante (391) zu der Streufläche des Gitters, das die Kollimationsachsen (351, 381) umfaßt, parallel ist, und daß das Gitter (31) und das Dieder (39) jeweils eine Orientierung aufweisen und die Laserquelle Mittel (401-407, 411-416, 418, 502, 504-505, 508-509) zum Einstellen der Orientierung des Gitters (31) und/oder des Dieders (39) aufweisen.

**2.** Kontinuierlich abstimmbare Monomodlaserquelle nach Anspruch 1,
**dadurch gekennzeichnet, daß** mit

einem Punkt A, der der Schnittpunkt der Kollimationsachsen (351, 381) und des Gitters (31) ist,
einem Punkt B', der das optische Ende des Resonanzraumes ist, das auf der Nebenkollimationsachse (381) zentriert und auf der Seite des reflektierenden Dieders (39) angeordnet ist,
einem Punkt C', der der Schnittpunkt der Hauptkollimationsachse (351) mit dem optischen Ende des Resonanzraumes ist, das sich auf der Seite des Verstärkermediums (33) befindet,
einem Punkt D, der der Schnittpunkt der Ebene (311), die die Brechungsfläche des Gitters (31) enthält, mit der Parallelen (392) zu der durch B'verlaufenden Schnittkante des Dieders (39) ist,

* der Winkel AC'D gleich 90° gehalten und
* die Länge AD konstant gehalten wird,

um eine kontinuierlich abstimmbare Quelle zu verwirklichen.

**3.** Abstimmbare Monomodlaserquelle nach einem der Ansprüche 1 und 2, **dadurch gekennzeichnet, daß** die Bewegungen des Gitters (31) und des Dieders (39) derart verbunden sind, daß sie gemeinsam beweglich und zueinander feststehend sind.

**4.** Kontinuierlich abstimmbare Monomodlaserquelle nach Anspruch 3, **dadurch gekennzeichnet, daß** das Gitter (41) und der Dieder (49) von einer Platte (401) getragen werden, die um eine Drehachse (409), die durch den Punkt A geht, drehbar ist, wobei diese Platte (401) mit einem Arm (402) mit einer Achse (410) fest verbunden ist, wobei dieser Arm (402) einen Auflagerpunkt (408) auf einer festen Translationsebene (403) in bezug auf ein Gehäuse (405) aufweist, wobei die Drehachse (409) von einem Element (414) getragen wird, das um eine Translationsbewegung parallel zur Kollimationsachse (45) in bezug auf das Gehäuse (405) beweglich ist, wobei die kontinuierliche Abstimmbarkeit der Quelle durch das Verschieben des beweglichen Elements (414) und das Halten des Auflagerpunktes (408) auf der Ebene (403) erzielt wird.

**5.** Kontinuierlich abstimmbare Monomodlaserquelle nach Anspruch 4, **dadurch gekennzeichnet, daß** eine Rückstellfeder (412), die an einem ihrer Enden an einem Arm (411) der Platte (401) und an dem anderen ihrer Enden (413) an dem Gehäuse (405) befestigt ist, den Halt des Auflagerpunktes (408) auf der Ebene (403) sichert.

**6.** Abstimmbare Monomodlaserquelle nach einem der Ansprüche 1 und 2, **dadurch gekennzeichnet, daß** das Gitter fest und der Dieder beweglich ist.

**7.** Kontinuierlich abstimmbare Monomodlaserquelle nach Anspruch 6, **dadurch gekennzeichnet, daß** der Dieder (591) von einer Stütze (502) getragen wird, die um eine Achse (503) beweglich ist, die auf der Streuebene senkrecht steht und durch den Punkt D verläuft.

8. Kontinuierlich abstimmbare Monomodlaserquelle nach Anspruch 7, **dadurch gekennzeichnet, daß** das Gitter (51) von einem Gehäuse (501) getragen wird und daß ein Motor (508), der mit dem Gehäuse (501) fest verbunden ist und einen Schieber (509), der mit der Stütze (502) verbunden ist, betätigt, die Ausrichtung des Dieders (59) steuert.

9. Abstimmbare Monomodlaserquelle nach einem der Ansprüche 1 bis 8, **dadurch gekennzeichnet, daß** das Verstärkermedium eine Laserdiode ist.

10. Abstimmbare Monomodlaserquelle nach Anspruch 9, **dadurch gekennzeichnet, daß** eine der Seiten der Laserdiode schwach reflektierend ist und die Ausgangsfläche zu dem externen Resonanzraum bildet.

11. Abstimmbare Monomodlaserquelle nach einem der Ansprüche 1 bis 8, **dadurch gekennzeichnet, daß** das Verstärkermedium eine dopierte optische Faser ist.

12. Abstimmbare Monomodlaserquelle nach einem der Ansprüche 6 bis 11, **dadurch gekennzeichnet, daß** ein Kollimationsbündel (533), das durch gewöhnliche Reflexion durch das Gitter (51) erzeugt wurde, eine Nutzquelle bildet.

**Claims**

1. Singlemode laser source tunable in wavelength with a self-aligned external cavity, comprising:

   a resonant cavity having a partially reflecting output face (232) and a retroreflecting dispersive device (31, 39), defining a main collimating axis (351) and a secondary collimating axis (381), for a beam (35),
   an amplifier wave guide (33) which is placed in position inside the resonant cavity and, generates said beam (35),

   **characterized in that** the retroreflecting dispersive device comprises a plane diffraction grating (31) having dispersion planes and an orthogonal reflecting dihedral (39) whose line of intersection (331) is parallel to the dispersion plane of the diffraction grating containing the said collimating axes (351, 381) and **in that** the diffraction grating (31) and the reflecting dihedral (39) are oriented and that the laser source comprises means (401-407, 411-416, 418-502, 504-505, 508-509) for adjusting the orientation of the diffraction grating (31) and/or the reflecting dihedral (39).

2. The tunable single mode laser source according to claim 1, **characterized in that**, for

   point A being the point of intersection of the collimating axes (351, 381) and the diffraction grating (31),
   point B' being the optical end of the cavity centered on the secondary collimating axis (352) and located on the side of the reflecting dihedral (39),
   point C' being the intersection of the main collimating axial (351) with the optical end of the cavity located on the side of the amplifier medium (33),
   point D being the intersection of the plane (311) containing the diffracting face of the diffraction grading (31) with the parallel (352) to the line of intersection of the dihedral (39) passing via B',

   • the angle AC'D is maintained equal to 90°,
   • the length AD is maintained constant,

   in such a way as to produce a continuously tunable source.

3. The tunable singlemode laser source according to one of claims 1 and 2, **characterised in that** the movements of the diffraction grating (31) and of the dihedral (39) are connected in such a way that they are mobile together and fixed with respect to each other.

4. The continuously tunable singlemode laser source according to claim 3, **characterised in that** the diffraction grating (41) and the dihedral (49) are supported by a plate (401) which can move in rotation about an axis of rotation (409) passing via the point A, said plate (401) being integral with an axis (410) arm (402), said arm (402) having a bearing point (408) on a plane (403) fixed in translation with respect to a frame (405), the axis of rotation (409) being supported by a mobile element (414) which can move in translation parallel to the axis of the collimated beam (45), with respect to the frame (405), the continuous tunability of the source being obtained by the displacement of the mobile element (414) and the maintaining of the bearing point (408) on the plane (403).

5. The continuously tunable singlemode laser source according to claim 4, **characterised in that** a return spring (412), fixed at one of its ends to an arm (411) of the plate (401) and at the other of its ends (413) to the frame (405), keeps the bearing point (408) pressed against the plane (403).

6. The tunable singlemode laser source according to one of claims 1 and 2, **characterised in that** the diffraction grating is fixed on the dihedral mobile.

7. The continuously tunable singlemode laser source according to claim 6, **characterised in that** the dihedral (591) is supported by a support (502) which can move about an axis (503) perpendicular to the dispersion plane and passing via the point D.

8. The continuously tunable singlemode laser source according of claim 7, **characterised in that** the diffraction grating (51) is supported by a frame (501) and a motor (508) integral with said frame (501) and activating a push-rod (509) connected to the support (502), controls the orientation of the dihedral (59).

9. The tunable singlemode laser source according to one of claims 1 to 8, **characterised in that** the amplifier medium is a laser diode.

10. The tunable singlemode laser source according to claim 9, **characterised in that** one of the faces of the laser diode is only slightly reflecting and constitutes the output face to the external cavity.

11. The tunable singlemode laser source according to one of claims 1 to 8 **characterised in that** the amplifier medium is a doped optical fiber.

12. The tunable singlemode laser source according to one of claims 6 to 11, **characterised in that** a collimated beam (533) produced by ordinary reflection on the diffraction grating (51) constitutes a useful source.

FIG.1  Art antérieur

FIG.2  Art antérieur

11

FIG. 3 A
Art antérieur

FIG. 3 B
Art antérieur

FIG.5

FIG.4

$\theta_1$

$\theta_2$

FIG.6

FIG. 7

FIG. 8

FIG.9